# EUROPEAN PATENT SPECIFICATION

(11) **EP 0 847 083 B1**
(45) Date of publication and mention of the grant of the patent: **22.03.2006**
(21) Application number: 97306270.6
(22) Date of filing: 19.08.1997
(51) Int. Cl.: H01L 21/3205, H01L 27/108

(54) **A method for manufacturing a capacitor for a semiconductor device**
Methode zur Herstellung eines Kondensators für eine Halbleiteranordnung
Méthode de fabrication d'un condensateur pour un dispositif à semi-conducteur

(30) Priority: 04.12.1996 KR 9661658
(43) Date of publication of application: 10.06.1998
(73) Proprietor: SAMSUNG ELECTRONICS CO., LTD., Suwon-City, Kyungki-do (KR)
(72) Inventor: Lee, Byoung-taek, Kwanak-gu, Seoul 151-050 (KR)
(74) Representative: Kyle, Diana

(56) References cited:
- EP-A- 0 697 717
- WO-A-96/17381
- US-A- 5 335 138
- US-A- 5 366 920
- US-A- 5 392 189
- CHEN T.-S. ET AL: 'Stability of reactive dc-sputtered Ir and IrO2 films in various ambients' INTEGRATED FERROELECTRICS vol. 16, 1997, AMSTERDAM, NETHERLANDS, pages 191 - 198, XP000856568

## Description

The present invention relates to a method of manufacturing a capacitor for a semiconductor device, and more particularly, to a method of manufacturing a lower electrode of a capacitor to which a thin film having a high dielectric constant is applied.

The decrease of cell capacitance along with a decrease in the area of a memory cell places a serious obstacle in increasing the integration level of DRAMs. The decrease of cell capacitance impedes the operation of a device at a low voltage as well as lowering the reading ability of a memory cell and increasing the soft error rate.

The charge amount Q of a capacitor is the product of capacitor capacitance C and an operation voltage V. That is, Q = C × V. Thus, to obtain a predetermined amount of charge with a decreased operation voltage, the capacitance should be increased. Assuming that the effective area of a capacitor is A, a dielectric constant in vacuum is ε₀, the relative dielectric constant of a dielectric εᵣ, and the thickness of the dielectric is d, the capacitance C is given as Aε₀εᵣ/d. Therefore, the capacitor capacitance C increases with a larger effective area A, a larger effective constant εᵣ of a dielectric layer, and a smaller thickness d of the dielectric layer.

To increase the effective area of a capacitor, three-dimensional lower electrode structures such as fin, box, and cylindrical structures have been suggested. However, it is hard to apply these three-dimensional lower electrode structures in real situations since their manufacturing processes are complicated and defects are likely to occur during the manufacturing processes.

Accordingly, research has been actively conducted on making a thin film of a material of a high dielectric constant to increase the capacitance. A capacitor having the thin film of high dielectric constant is more preferred in terms of the high integration level of semiconductor devices as well as process simplication, because a capacitor to which a thin film having a high dielectric constant is applied can secure a sufficient capacitance with a simple two-dimensional lower electrode.

However, when a lower electrode is formed of impurity-doped polysilicon as in prior art, a material of a high dielectric constant reacts with polysilicon, and thus a new dielectric layer having a very low dielectric constant is formed at their interface, thereby decreasing the entire capacitance. Therefore, there is an increasing need for a new structure of a lower electrode suitable for a capacitor to which a thin film of a high dielectric constant is applied in a semiconductor device.

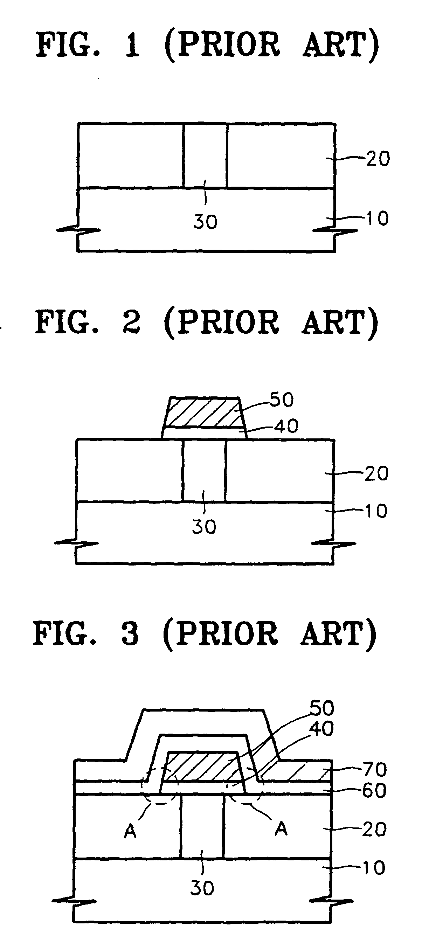

FIGS. 1, 2, and 3 are sectional views for explaining a conventional method for manufacturing a capacitor for a semiconductor device, as in Chen et al., "Stability of reactive dc-sputtered Ir and IrO₂ films in various ambients," Integrated Ferroelectrics, vol. 16, 1997, pp 191-198.

FIG. 1 illustrates the step of forming an interlayer insulating layer pattern 20 and a contact plug 30. The interlayer insulating layer pattern 20 is formed on a semiconductor substrate 10 to have a contact hole exposing a predetermined area of the semiconductor substrate 10. Subsequently, an impurity-doped polysilicon layer is formed on the resultant structure having the interlayer insulating layer pattern 20, to fill the contact hole. Then, the contact plug 30 is formed in the contact hole by completing etching the polysilicon layer till the interlayer insulating layer pattern 20 is exposed.

FIG. 2 illustrates the step of completing a lower electrode constituted of the contact plug 30, a diffusion barrier layer pattern 40, and a conductive layer pattern 50 by forming the diffusion barrier layer 40 and the conductive layer pattern 50. First, a diffusion barrier layer and a conductive layer are sequentially formed of a titanium nitride (TiN) and platinum (Pt), respectively, on the resultant structure having the contact plug 30 formed therein.

Then, the diffusion barrier layer pattern 40 and the conductive layer pattern 50 are formed to be sequentially stacked on the contact plug 30 by sequentially etching the conductive layer and the diffusion barrier layer till the interlayer insulating layer pattern 20 is exposed, that is, the lower electrode is completed, which has the contact plug 30, the diffusion barrier layer pattern 40, and the conductive layer pattern 50. The diffusion barrier layer pattern 40 serves to prevent the capacitance of a capacitor from decreasing due to reaction between the contact plug 30 and the conductive layer pattern 50 in a subsequent dielectric forming process.

FIG. 3 illustrates the step of completing the capacitor by forming a dielectric layer 60 and an upper electrode 70. First, an amorphous dielectric layer containing Ba, Sr, Ti, and O is formed on the resultant having the lower electrode formed thereon by chemical vapor deposition (CVD) or sputtering. Then, the resultant including the amorphous dielectric layer is heat-treated at 500-750°C so that the amorphous dielectric layer is crystallized. Thus, a crystalline dielectric layer 60 is formed of (Ba, Sr)TiO₂ of a perovskite structure. The crystalline dielectric layer 60 is referred to as the dielectric layer 60, hereinafter.

Alternatively, the dielectric layer 60 can be formed in an in-situ method where materials respectively containing Ba, Sr, Ti, and O are deposited on the resultant including the lower electrode, while the resultant including the lower electrode is being heat-treated at 500-750°C. Then, the upper electrode 70 is formed on the dielectric layer 60, thus completing the capacitor.

Anyway, the dielectric forming step is necessarily accompanied by the above-described heat treatment. Since a sidewall A of the diffusion barrier layer pattern 40 makes contact with the amorphous dielectric layer containing oxygen, the oxygen penetrates into the sidewall A of the diffusion barrier layer pattern 40 during the heat treatment, thus oxidizing the diffusion barrier layer pattern 40 and the contact plug 30. That is, materials having a low dielectric constants such as TiO₂ and SiO₂ are formed.

When the dielectric layer 60 is formed in-situ, the diffusion barrier layer pattern 40 and the contact plug 30 are also oxidized because the sidewall of the diffusion barrier layer pattern 40 is exposed to an oxygen atmosphere. In addition, the diffusion barrier layer pattern 40 and the contact plug 30 are likely to be oxidized by oxygen penetrating into the diffusion barrier layer pattern 40 through the conductive layer pattern 40.

Consequently, according to the conventional method of manufacturing a capacitor for a semiconductor device, though the diffusion barrier layer pattern 40 prevents the contact plug 30 and the conductive layer pattern 50 from reacting at their interface, oxygen penetrating into the sidewall of the diffusion barrier layer pattern 40 and the conductive layer pattern 50 during the step of forming the dielectric layer 60 oxidizes the diffusion barrier layer pattern 40 and the contact plug 30, thus producing materials of low dielectric constants such as TiO₂ and SiO₂. As a result, the capacitance of the capacitor is remarkably reduced.

According to a first aspect of the present invention, a method of manufacturing a capacitor for a semiconductor device, comprises the steps of:
(a) forming a first interlayer insulating layer having a first contact hole on a semiconductor substrate;
(b) forming a contact plug to fill said first contact hole;
(c) forming a diffusion barrier layer pattern on said contact plug and on a portion of the surface of the first interlayer insulating layer adjacent the contact plug;
(d) forming a second interlayer insulating layer pattern having a second contact hole which exposes said diffusion barrier layer pattern on the resultant including the diffusion barrier layer pattern;
(e) forming a conductive layer pattern to make contact with said diffusion barrier layer pattern through said second contact hole to complete a lower electrode including said contact plug, said diffusion barrier layer pattern, and a conductive layer pattern; and
(f) sequentially forming a dielectric layer and an upper electrode on said conductive layer pattern.

The contact plug may be formed of one selected from a group consisting of impurity-doped polysilicon, tungsten (W), tungsten nitride (WN), and tungsten silicide (WSix), and the diffusion barrier layer pattern formed of one selected from a group consisting of Ta, Co, TiN, (Ti, Al)N, (Ti, Si)N, TaN, (Ta, Si)N, TiSix, TaSix, and CoSiX.

The conductive layer pattern may be formed of one selected from a group consisting of platinum (Pt), iridium (Ir), ruthenium (Ru), iridium dioxide (IrO₂), and ruthenium dioxide (RuO₂), and the contact plug, the diffusion barrier layer pattern, and the conductive layer pattern formed of impurity-doped polysilicon, titanium nitride (TiN), and platinum (Pt), respectively.

According to a second aspect of the present invention, a method of manufacturing a capacitor for a semmiconductor device, comprises the steps of:
(a) forming a first interlayer insulating layer pattern having a first contact hole on a semiconductor substrate;
(b) forming a contact plug to fill the first contact hole;
(c) forming a first diffusion barrier layer pattern on the contact plug and on a portion of the surface of the first interlayer insulating layer adjacent the contact plug;
(d) forming a second interlayer insulating layer pattern having a second contact hole which exposes the first diffusion barrier layer pattern
(e) forming a second diffusion barrier layer pattern to rill the second contact hole;
(f) forming a conductive layer pattern on the second diffusion barrier layer pattern to complete a lower electrode including the contact plug, said first diffusion barrier layer pattern, said second diffusion barrier layer pattern, and the conductive layer pattern; and
(g) sequentially forming a dielectric layer and an upper electrode on the conductive layer pattern.

The contact plug may be formed of one selected from a group consisting of impurity-doped polysilicon, tungsten (W), tungsten nitride (WN), and tungsten silicide (WSix), and the first diffusion barrier layer pattern formed of one selected from a group consisting of Ta, Co, TiN, (Ti, Al)N, (Ti, Si)N, TaN, (Ta, Si)N, TiSix, TaSix, and CoSix.

The second diffusion barrier layer pattern may be formed of one selected from a group consisting of Ir, Ru, IrO₂, and RuO₂, and the conductive layer pattern formed of Pt.

The second diffusion barrier layer may be formed to have a double-layer structure where Ir and IrO2 are sequentially stacted, and the conductive layer pattern is formed of Pt.

The method of manufacturing a capacitor for a semiconductor device according to the present invention prevents reduction of the capacitance of the capacitor due to oxidation of a portion of the lower electrode by preventing oxidation of the diffusion barrier layer pattern.

Examples of the present invention will now be described in detail with reference to the accompanying drawings, in which:

The above object and advantages will become more apparent by describing in detail preferred embodiments thereof with reference to the attached drawings in which:
FIGS. 1, 2, and 3 are sectional views for explaining a conventional method of manufacturing a capacitor for a semiconductor device;
FIGS. 4, 5, and 6 are sectional views for explaining a method of manufacturing a capacitor for a semiconductor device according to an embodiment of the present invention; and
FIGS. 7, 8, and 9 are sectional views for explaining a method of manufacturing a capacitor for a semiconductor device according to another embodiment of the present invention.

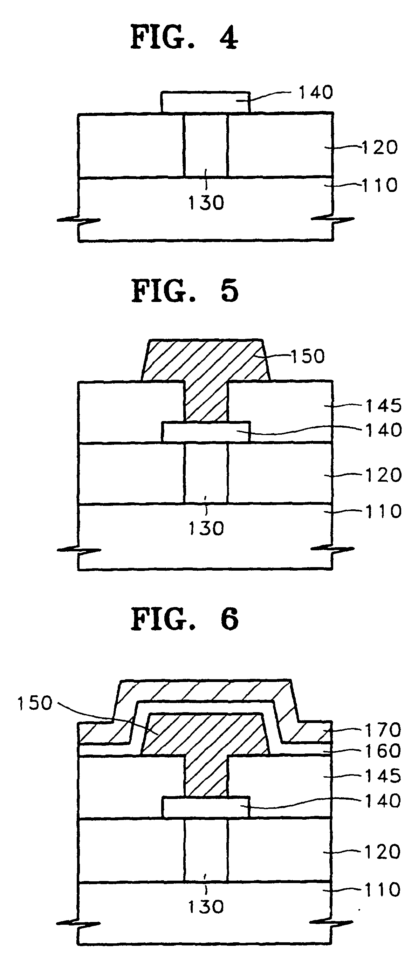

FIG. 4 illustrates the step of forming a first interlayer insulating layer pattern 120, a contact plug 130, and a diffusion barrier layer pattern 140. The first interlayer insulating layer pattern 120 is formed on a semiconductor substrate 110 to have a first contact hole exposing a predetermined area of the semiconductor substrate 110.

Then, a first conductive layer is formed on the resultant including the first interlayer insulating layer pattern 120, to fill the first contact hole. The first conductive layer is formed of impurity-doped polysilicon, tungsten (W), tungsten nitride (WN), or tungsten silicide (WSix). Subsequently, the contact plug 130 is formed in the first contact hole by completly etching the first conductive layer till the first interlayer insulating layer pattern 120 is exposed.

A diffusion barrier layer is formed of Ta, Co, TiN, (Ti, Al)N, (Ti, Si)N, TaN, (Ta, Si)N, TiSix, TaSix, or CoSix on the resultant including the contact plug 130. Here, the diffusion barrier layer serves to prevent reaction between the contact plug 130 and a conductive layer pattern 150 of FIG. 5. Then, the diffusion barrier layer pattern 140 is formed on the contact plug 130 and on a portion of the surface of the first interlayer insulating layer adjacent the contact plug by etching the diffusion barrier layer till the first interlayer insulating layer pattern 120 is exposed.

FIG. 5 illustrates the step of forming a second interlayer insulating layer pattern 145 and a conductive layer pattern 150, thus completing a lower electrode having the contact plug 130, the diffusion barrier layer pattern 140, and the conductive layer pattern 150.

First, a second interlayer insulating layer is formed on the resultant including the diffusion barrier layer pattern 140. Then, the second interlayer insulating layer pattern 145 is formed to have a second contact hole by etching the second interlayer insulating layer till the diffusion barrier layer pattern 140 is exposed. A second conductive layer is formed of platinum (Pt), iridium (Ir), ruthenium(Ru), iridium dioxide (IrO₂), or ruthenium dioxide (RuO₂).

Then, the conductive layer pattern 150 is formed on the second interlayer insulating layer pattern 145 to make contact with the diffusion barrier layer pattern 140 through the second contact hole by patterning the second conductive layer till the second interlayer insulating layer pattern 145 is exposed. That is, the lower electrode having the contact plug 130, the diffusion barrier layer pattern 140, and the conductive layer pattern 150 is completed.

FIG. 6 illustrates the step of completing the capacitor of the present invention by forming a dielectric layer 160 and an upper electrode 170. First, an amorphous dielectric layer is formed on the resultant having the completed lower electrode thereon. Then, the resultant is heat-treated to crystallize the amorphous dielectric layer, thus forming a crystalline dielectric layer 160 of SrTiO₃, (BaSr)TiO₃, (Pb, Zr)TiO₃, or (Pb, Zr)(Ti, La)TiO₃. Alternately, the crystalline dielectric layer 160 may be formed in-situ, while the resultant including the lower electrode is heat-treated. The crystalline dielectric layer 160 is referred to as the dielectric layer 160, hereinafter. Then, the upper electrode 170 is formed on the dielectric layer 160, thus completing the capacitor of the present invention.

Here, since the diffusion barrier layer pattern 140 does not contact with the amorphous dielectric layer, oxygen cannot react with the diffusion barrier layer pattern 140 during the heat treatment, in contrast to the prior art. Therefore, oxidation of the diffusion barrier layer pattern 140 and the contact plug 130 is prevented. When the dielectric layer 160 is formed in-situ, oxidation of the diffusion barrier layer pattern 142 and the contact plug 130 can be also prevented because the diffusion barrier layer pattern 142 is not exposed to an oxygen atmosphere.

Even if the second interlayer insulating layer 145 is thin based on its surface, it takes a larger amount of time for oxygen to reach the diffusion barrier layer pattern 140 through the conductive layer pattern 150 because the conductive layer pattern 150 contacts the diffusion barrier layer pattern 140 through the second contact hole. Accordingly, oxidation of the diffusion barrier layer pattern 140 due to oxygen introduced through the conductive layer pattern 150 can be prevented.

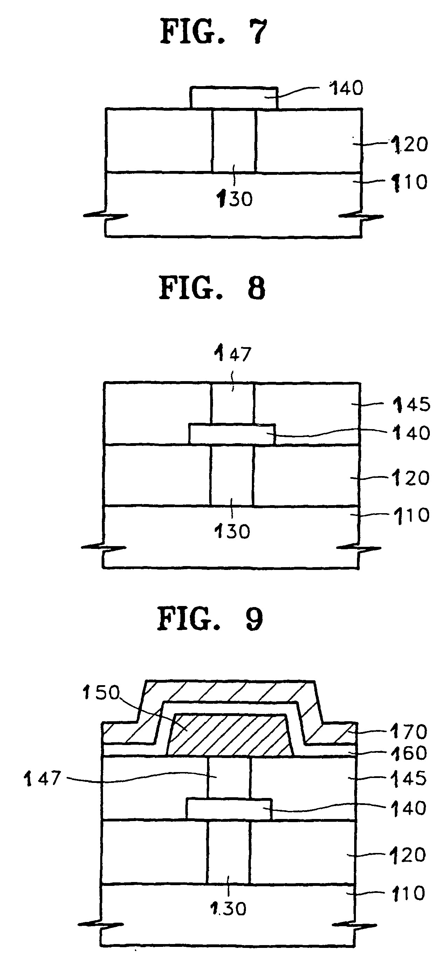

FIGS. 7, 8, and 9 are sectional views for explaining a method of manufacturing a capacitor for a semiconductor device according to a second embodiment of the present invention.

FIG. 7 illustrates the step of forming a first interlayer insulating layer pattern 120, a contact plug 130, and a first diffusion barrier layer pattern 140. First, the first interlayer insulating layer pattern 120 is formed on a semiconductor substrate 110 to have a first contact hole exposing a predetermined area of the semiconductor substrate 110. Then, a first conductive layer is formed of impurity-dope polysilicon, tungsten (W), tungsten nitride (WN), or tungsten silicide (WSix) to fill the first contact hole, on the resultant including the first interlayer insulating layer pattern 120. Subsequently, the contact plug 130 is formed in the first contact hole by completly etching the first conductive layer till the first interlayer insulating layer pattern 120 is exposed.

A first diffusion barrier layer is formed of Ta, Co, TiN, (Ti, Al)N, (Ti, Si)N, TaN, (Ta, Si)N, TiSix, TaSix, or CoSix on the resultant including the contact plug 130. Here, the first diffusion barrier layer serves to prevent reaction between the contact plug 130 and a second diffusion barrier layer pattern 147 of FIG. 8. Then, the first diffusion barrier layer pattern 140 is formed on the contact plug 130 and on a portion of the surface of the first interlayer insulating layer adjacent the contact plug by etching the first diffusion barrier layer till the interlayer insulating layer pattern 145 is exposed.

FIG. 8 illustrates the step of forming a second interlayer insulating layer 145 and a second diffusion barrier layer pattern 147.

First, a second interlayer insulating layer is formed on the resultant including the first diffusion barrier layer pattern 140. Then, the second interlayer insulating layer pattern 145 is formed to have a second contact hole by patterning the second interlayer insulating layer till the first diffusion barrier layer pattern 140 is exposed.

Then, a diffusion barrier layer is formed of iridium (Ir), ruthenium (Ru), iridium dioxide (IrO₂), or ruthenium dioxide (RuO₂) to fill the second contact hole, on the second interlayer insulating layer pattern 145. Here, the second diffusion barrier layer can be formed to have a double-layer structure where iridium and iridium dioxide are sequentially stacked to increase the adhesiveness between the second diffusion barrier layer and a conductive layer pattern 150 of FIG 9.

Then, the second diffusion barrier layer pattern 147 is formed in the second contact hole by completly etching the second diffusion barrier layer till the second interlayer insulating layer pattern 145 is exposed. Here, the second diffusion barrier layer pattern 147 serves to prevent oxidation of the first diffusion barrier layer pattern 140.

FIG. 9 illustrates the steps of completing a lower electrode including the contact plug 130, the first diffusion barrier layer pattern 140, the second diffusion barrier layer pattern 147, and the conductive layer pattern 150, and completing the capacitor of the present invention by forming a dielectric layer 160 and an upper electrode 170.

First, a second conductive layer is formed on the resultant including the second diffusion barrier layer pattern 147 using platinum (Pt). Then, the conductive layer pattern 150 is formed on the second diffusion barrier layer pattern 147 by patterning the second conductive layer till the second interlayer insulating layer pattern 145 is exposed. That is, the lower electrode having the contact plug 130, the first diffusion barrier layer pattern 140, the second diffusion barrier layer pattern 147, and the conductive layer pattern 150 is completed.

Subsequently, an amorphous dielectric layer is formed on the resultant having the completed lower electrode thereon. Then, the resultant including the amorphous dielectric layer is heat-treated to crystallize the amorphous dielectric layer, thus forming a crystalline dielectric layer 160 of SrTiO₃, (BaSr)TiO₃, (Pb, Zr)TiO₃, or (Pb, Zr)(Ti, La)TiO₃. Alternativly, the crystalline dielectric layer 160 may be formed in-situ, while the resultant including the lower electrode is heat-treated. The crystalline dielectric layer 160 is referred to as the dielectric layer 160, hereinafter. Then, the upper electrode 170 is formed on the dielectric layer 160, thus completing the capacitor of the present invention.

Here, since the first diffusion barrier layer pattern 140 makes no contact with the amorphous dielectric layer, oxidation of the first diffusion barrier layer pattern 140 is prevented during the heat-treatment. When the dielectric layer 160 is formed in in-situ, oxidation of the diffusion first barrier layer pattern 140 is prevented because the first diffusion barrier layer pattern 140 is not exposed to an oxygen atmosphere.

Furthermore, reaction between oxygen introduced through the conductive layer pattern 150 and the first diffusion barrier layer pattern 140 can be prevented by forming the second diffusion barrier layer pattern 147.

As described above, in the present invention, reduction of the capacitance of the capacitor due to oxidation of a portion of the lower electrode can be prevented by preventing oxidation of the diffusion barrier layer pattern 140.

## Claims

1. A method of manufacturing a capacitor for a semiconductor device, comprising the steps of:
(a) forming a first interlayer insulating layer(120) having a first contact hole on a semiconductor substrate (110) ;
(b) forming a contact plug (130) to fill said first contact hole;
(c) forming a diffusion barrier layer pattern (140) on said contact plug (130)and on a portion of the surface of the first interlayer insulating layer (120) adjacent to the contact plug (130);
(d) forming a second interlayer insulating layer pattern (145) having a second contact hole which exposes said diffusion barrier layer pattern;
(e) forming a conductive layer pattern (150) to make contact with said diffusion barrier layer pattern (140) through said second contact hole to complete a lower electrode including said contact plug (130), said diffusion barrier layer pattern (140), and a conductive layer pattern (150); and
(f) sequentially forming a dielectric layer (160) and an upper electrode (170) on said conductive layer pattern.

2. A method according to claim 1, wherein the diffusion barrier layer pattern (140) is formed of one selected from Ta, Co, TiN, (Ti, Al)N, (Ti, Si)N, TaN, (Ta, Si)N, TiSix, TaSix, and CoSix.

3. A method according to claim 1 or 2, wherein the conductive layer pattern (150) is formed of one selected from platinum (Pt), iridium (Ir), ruthenium (Ru), iridium dioxide (IrO₂), and ruthenium dioxide (RuO₂).

4. A method according to any preceding claim, wherein the contact plug (130), said diffusion barrier layer pattern (140), and said conductive layer pattern (150) are formed of impurity-doped plysilicon, titanium nitride (TiN), and platinum (Pt), respectively.

5. A method according to claim 1, wherein a second diffusion barrier layer pattern (147) is formed to fill the second contact hole, and the conductive layer pattern (150) is formed on the second diffusion barrier layer pattern (147) to complete a lower electrode including the contact plug (130), the first and second diffusion barrier layer patterns (140, 147) and the conductive layer pattern (150)

6. A method according to claim 5, wherein the first diffusion barrier layer pattern (140) is formed of one selected from Ta, Co, TiN, (Ti, Al)N, (Ti, Si)N, TaN, (Ta, Si)N, TiSix, TaSix, and CoSix.

7. A method according to claim 5 or 6, wherein the second diffusion barrier layer pattern (147) is formed of one selected from Ir, Ru, IrO₂, and RuO₂.

8. A method according to any one of claims 5 to 7, wherein the conductive layer pattern (150) is formed of Pt.

9. A method according to any one of claims 5 to 8, wherein the second diffusion barrier layer (147) is formed to have a double-layer structure where Ir and IrO₂ are sequentially stacked, and the conductive layer pattern (150) is formed of Pt.

10. A method according to any preceding claim, wherein said contact plug (130) is formed of one selected from impurity-doped polysilicon, tungsten (W), tungsten nitride (WN), and tungsten silicide (WSix).

## Patentansprüche

1. Verfahren zur Herstellung eines Kondensators für eine Halbleiteranordnung umfassend die Schritte:
(a) Ausbilden einer ersten Zwischenisolierschicht (120) mit einem ersten Kontaktdurchtritt auf einem Halbleitersubstrat (110);
(b) Ausbilden eines Kontaktsteckers (130) zum Ausfüllen des ersten Kontaktdurchtritts;
(c) Ausbilden eines Diffusionsbarriereschichtmusters (140) auf dem Kontaktstecker (130) und auf einem Teil der Oberfläche der ersten Zwischenisolierschicht (120) neben dem Kontaktstecker (130);
(d) Ausbilden eines zweiten Zwischenisolierschichtmusters (145) mit einem zweiten Kontaktdurchtritt, der das Diffusionsbarriereschichtmuster freilegt;
(e) Ausbilden eines Leitschichtmusters (150) zur Kontaktherstellung mit dem Diffusionsbarriereschichtmuster (140) durch den zweiten Kontaktdurchtritt zur Bildung einer unteren Elektrode mit dem Kontaktstecker (130), dem Diffusionsbarriereschichtmuster (140) und einem Leitschichtmuster (150); und
(f) sequentielles Ausbilden einer dielektrischen Schicht (160) und einer oberen Elektrode (170) auf dem Leitschichtmuster.

2. Verfahren nach Anspruch 1, worin das Diffusionsbarriereschichtmuster (140) aus einem ausgewählt aus Ta, Co, TiN, (Ti, Al)N, (Ti, Si)N, TaN, (Ta,Si)N, TiSix, TaSix und CoSix gebildet wird.

3. Verfahren nach Anspruch 1 oder 2, worin das Leitschichtmuster (150) aus einem ausgewählt aus Platin (Pt), Iridium (Ir), Ruthenium (Ru), Iridiumdioxid (IrO₂) und Rutheniumdioxid (RuO₂) gebildet wird.

4. Verfahren nach einem der vorhergehenden Ansprüche, worin der Kontaktstecker (130), das Diffusionsbarriereschichtmuster (140) und das Leitschichtmuster (150) aus mit Fremdstoff dotiertem Polysilicium, Titannitrid (TiN) bzw. Platin (Pt) gebildet werden.

5. Verfahren nach Anspruch 1, worin ein zweites Diffusionsbarriereschichtmuster (147) ausgebildet wird, um den zweiten Kontaktdurchtritt zu füllen, und das Leitschichtmuster (150) auf dem zweiten Diffusionsbarriereschichtmuster (147) zum Bilden einer unteren Elektrode mit dem Kontaktstecker (130), dem ersten und zweiten Diffusionsbarriereschichtmuster (140, 147) und dem Leitschichtmuster (150) gebildet wird.

6. Verfahren nach Anspruch 5, worin das erste Diffusionsbarriereschichtmuster (140) aus einem ausgewählt aus Ta, Co, TiN, (Ti, Al)N, (Ti, Si)N, TaN, (Ta, Si)N, TiSix, TaSix und CoSix gebildet wird.

7. Verfahren nach Anspruch 5 oder 6, worin das zweite Diffusionsbarriereschichtmuster (147) aus einem ausgewählt aus Ir, Ru, IrO₂ und RuO₂ gebildet wird.

8. Verfahren nach einem der Ansprüche 5 bis 7, worin das Leitschichtmuster (150) aus Pt gebildet wird.

9. Verfahren nach einem der Ansprüche 5 bis 8, worin die zweite Diffusionsbarriereschicht (147) so ausgebildet wird, dass eine Doppelschichtstruktur erhalten wird, wo Ir und IrO₂ sequentiell aufgelagert werden und das Leitschichtmuster (150) aus Pt gebildet wird.

10. Verfahren nach einem der vorhergehenden Ansprüche, worin der Kontaktstecker (130) aus einem ausgewählt aus mit Fremdstoff dotiertem Polysilicium, Wolfram (W), Wolframnitrid (WN) und Wolframsilicid (WSix) gebildet wird.

## Revendications

1. Méthode de fabrication d'un condensateur pour un dispositif à semi-conducteur, comprenant les étapes de :
(a) formation d'une première couche isolante de couche intermédiaire (120) ayant un premier trou de contact sur un substrat semi-conducteur (110) ;
(b) formation d'une fiche de contact (130) destinée à s'emboîter dans le premier trou de contact ;
(c) formation d'un motif de barrière de diffusion de la pellicule (140) sur ladite fiche de contact (130) et sur une partie de la surface de la première couche isolante de couche intermédiaire (120) adjacente à la fiche de contact (130) ;
(d) formation d'un deuxième motif de couche isolante de couche intermédiaire (145) ayant un deuxième trou de contact qui expose ledit motif de barrière de diffusion de la pellicule ;
(e) formation d'un motif de couche conductrice (150) pour obtenir un contact avec ledit motif de barrière de diffusion de la pellicule (140) au moyen dudit deuxième trou de contact afin de compléter une électrode inférieure comprenant ladite fiche de contact (130), ledit motif de barrière de diffusion de la pellicule (140) et un motif de couche conductrice (150) ; et
(f) formation de manière séquentielle d'une couche diélectrique (160) et d'une électrode supérieure (170) sur ledit motif de couche conductrice.

2. Méthode selon la revendication 1, dans laquelle le motif de barrière de diffusion de la pellicule (140) est formé d'un matériau sélectionné parmi les matériaux suivants : Ta, Co, TiN, (Ti, Al)N, (Ti, Si)N, TaN, (Ta, Si)N, TiSix, TaSix et CoSix.

3. Méthode selon la revendication 1 ou 2, dans laquelle le motif de couche conductrice (150) est formé d'un matériau sélectionné parmi les matériaux suivants : le platine (Pt), l'iridium (Ir), le ruthénium (Ru), le dioxyde d'iridium (IrO₂) et le dioxyde de ruthénium (RuO₂).

4. Méthode selon l'une quelconque des revendications précédentes, dans laquelle la fiche de contact (130), ledit motif de barrière de diffusion de la pellicule (140) et ledit motif de couche conductrice (150) sont formés de polysilicone, de nitrure de titane (TiN) et de platine (Pt) dopés avec des impuretés, respectivement.

5. Méthode selon la revendication 1, dans laquelle un deuxième motif de barrière de diffusion de la pellicule (147) est formé pour s'emboîter dans le deuxième trou de contact, et le motif de couche conductrice (150) est formé sur le deuxième motif de barrière de diffusion de la pellicule (147) pour compléter une électrode inférieure comprenant la fiche de contact (130), les premier et deuxième motifs de barrière de diffusion de la pellicule (140, 147) et le motif de couche conductrice (150).

6. Méthode selon la revendication 5, dans laquelle le premier motif de barrière de diffusion de la pellicule (140) est formé d'un matériau sélectionné parmi les matériaux suivants : Ta, Co, TiN, (Ti, Al)N, (Ti, Si)N, TaN, (Ta, Si)N, TiSix, TaSix et CoSix.

7. Méthode selon la revendication 5 ou 6, dans laquelle le deuxième motif de barrière de diffusion de la pellicule (147) est formé d'un matériau sélectionné parmi les matériaux suivants : Ir, Ru, IrO₂ et RuO₂.

8. Méthode selon l'une quelconque des revendications 5 à 7, dans laquelle le motif de couche conductrice (150) est formé de Pt.

9. Méthode selon l'une quelconque des revendications 5 à 8, dans laquelle le deuxième motif de barrière de diffusion de la pellicule (147) est formé de façon à avoir une structure à double couche lorsque Ir et IrO₂ sont superposés de manière séquentielle, et le motif de couche conductrice (150) est formé de Pt.

10. Méthode selon l'une quelconque des revendications précédentes, dans laquelle ladite fiche de contact (130) est formée d'un matériau sélectionné parmi les matériaux suivants : le polysilicone, le tungstène (W), le nitrure de tungstène (WN) et le siliciure de tungstène (Wsix) dopés avec des impuretés.
